# EUROPEAN PATENT APPLICATION

(11) **EP 1 463 384 A2**
(43) Date of publication of application: **29.09.2004**
(21) Application number: 04251652.6
(22) Date of filing: 23.03.2004
(51) Int. Cl.: H05B 33/10, H05B 33/26

(54) **Electro-optic apparatus, method of manufacturing the same and display apparatus**

(30) Priority: 27.03.2003 JP 2003089333
(71) Applicant: SEIKO EPSON CORPORATION, Shinjuku-ku, Tokyo 163-0811 (JP)
(72) Inventor: Okuyama, Tomoyuki c/o Seiko Epson Corporation, Suwa-shi Nagano-ken 392-8502 (JP); Kimura, Mutsumi c/o Seiko Epson Corporation, Suwa-shi Nagano-ken 392-8502 (JP)
(74) Representative: Sturt, Clifford Mark

(57) **Abstract**

The invention seeks to provide a technology for connecting a plurality of functional devices, being formed respectively on two substrates so as to correspond to a plurality of pixels, with respect to each other. An electro-optical apparatus having a plurality of pixel areas, wherein a first substrate (11) formed thereon with a plurality of first functional devices corresponding to the plurality of pixel areas respectively and a second substrate (21) formed thereon with a plurality of second functional devices corresponding to the plurality of pixel areas respectively, and the first functional devices and the second functional devices are connected with respect to each other by a

## Description

The present invention relates to an electro-optical apparatus (display apparatus) including a plurality of pixels disposed, for example, in a matrix, and a technology of manufacturing the same.

In an electro-optical apparatus, connecting different functional devices is required in many cases. For example, in an organic electro-luminescence display driven by a thin film transistor, which is an electro-optical apparatus, it is necessary to connect the thin film transistor and the organic electro-luminescence device. In the related art, the organic electro-luminescence device is laminated on the thin film transistor, and a cathode is formed thereon to manufacture a display. However, in the case where the thin film transistor is formed in advance, and the organic electro-luminescence device is formed thereon, and then the cathode is formed further thereon, the cathode blocks light emission. Therefore, it is difficult to employ a top emission structure in which the upper portion of the substrate is used as a light emitting section, which results in employment of a bottom emission structure in which light is emitted from the bottom portion of the substrate. However, since the portion of the thin film transistor cannot be used as a light emitting section, the rate of the light emission area is decreased. It is also necessary to increase the current and voltage to be applied to the organic electro-luminescence device to secure the light amount (luminance) in order to compensate the deficiency of the rate of light emission area. Therefore, the duration during which the light emission efficiency of the organic electro-luminescence device can be maintained may be shortened.

On the other hand, in order to employ the top emission structure, it is necessary to form the thin film transistor, and subsequently, form the cathode by depositing a metal of low work function thereon, and then form the organic electro-luminescence device. However, it is difficult to maintain the cathode interface in the active state all along from the formation of the cathode metal to the formation of the organic electro-luminescence device. This is due to the oxidation of the cathode interface, for example. Therefore, it is difficult to manufacture the organic electro-luminescence display driven by the thin film transistor with the top emission.

In such background, an approach of providing a first substrate formed with a plurality of first functional devices corresponding to a plurality of pixels and a second substrate formed with second functional devices corresponding to the plurality of pixels, and connecting them together is contemplated in the final step. According to this approach, since the first substrate and the second substrate can be manufactured separately, constraint in manufacturing is reduced, and thus optimization of the manufacturing process of each substrate is facilitated. In addition, application of such construction to the organic electro-luminescence display driven by the thin film transistor facilitates optimization of the manufacturing processes for each of the thin film transistor and the organic electro-luminescence device. In addition, since it is not necessary to take into account the high-temperature condition, which is required in the manufacturing process of the thin film transistor, when manufacturing the organic electro-luminescence device, the organic electro-luminescence device of the top emission type may be manufactured. Therefore, significant improvement of the rate of light emission area and power saving in association therewith may be realized, and thus improvement of the duration during which the light emission efficiency of the organic electro-luminescence device can be maintained may be expected. As a known reference relating to a method of realizing the above-described structure, there is, for example, Japanese Unexamined Patent Application Publication No. 11-3048 (Patent Document 1).

However, in Patent Document 1, there is no detail and concrete statement about how to achieve pixel-by-pixel connection of the functional devices formed on two substrates respectively so as to correspond to the pixels arranged in a matrix form in the method of manufacturing the same.

Accordingly, it is an object of the present invention to provide a technology which enables easy connection between functional devices which are formed respectively on two substrates.

In order to solve the problem described above, an electro-optical apparatus according to the present invention, being an electro-optical apparatus having a plurality of pixels, includes a first substrate formed with a plurality of first functional devices corresponding to the plurality of pixels respectively, and a second substrate formed with a plurality of second functional devices corresponding to the plurality of pixels and being adhered to the first substrate, and is characterized in that the first functional devices and the second functional devices are connected with respect to each other via a conductive paste.

An electro-optical apparatus according to the present invention, being an electro-optical apparatus including a plurality of pixels, includes a first substrate formed with a device chip including one or a plurality of first functional devices corresponding to the plurality of pixels respectively and a second substrate formed with a plurality of second functional devices corresponding to the plurality of pixels respectively and being adhered to the first substrate, and is characterized in that the device chip and the second functional device are connected with respect to each other via a conductive paste.

Since the first substrate formed with the first functional device or the device chip and the second substrate formed with the second functional device are connected via the conductive paste, the respective structures and the manufacturing processes of the first substrate and the second substrate may be optimized.

Preferably, the conductive paste is formed by a screen process printing.

Preferably, the conductive paste also serves as a spacer between the first substrate and the second substrate. Accordingly, the structure may be simplified.

Preferably, the first functional device on the first substrate is a thin film transistor.

Also preferably, the second functional device on the second substrate is an electro-optic device and especially, an organic electro-luminescence device.

The present invention is also electronic equipment constructed by using the above-described electro-optical apparatus according to the present invention.

In this specification, the term "pixel area" represents an area which defines a zone of pixels formed on the display area, and the term "pixel" is a smallest unit for displaying a predetermined image. Each pixel includes at least an electro-optical device and an electrode. The term "electro-optical apparatus" used in the present invention represents a general apparatus provided with an electro-optical device for changing the state of light emitted by the electrical action or of light from the outside, and include both the one which self-emits light and the one which controls transmission of light from the outside. The "electro-optical device" includes the above-described EL (electro-luminescence) device, a liquid crystal device, an electrophoresis device, and an electro-emission device which allows an electron generated by application of an electric field to be applied on a luminescent screen to emit light.

The term electronic equipment" in the present invention represents general equipment which can implement a certain function by the combination of a plurality of devices or circuits, and includes, for example, an electro-optical apparatus and a memory. The electronic equipment may include one or a plurality of circuit boards. Though the structure thereof is not limited specifically, for example, it includes an IC card, a mobile telephone set, a video camera, a personal computer, a head-mount display, a rear-type or a front-type projector, a facsimile device having a display function, a finder of a digital camera, a portable TV, a DSP apparatus, a PDA, an electronic databook, an electric bulletin board, and a display for advertisement.

The present invention is a method of manufacturing an electro-optical apparatus having a plurality of pixels, including a first step of forming a plurality of the first functional devices corresponding to the plurality of pixels respectively on a first substrate, a second step of forming a plurality of second functional devices corresponding to the plurality of pixels on a second substrate, a third step of forming a conductive paste for connecting the first functional device and the second functional device on at least one of the first substrate and the second substrate, and a fourth step of adhering the first substrate and the second substrate.

The present invention is also a method of manufacturing an electro-optical apparatus having a plurality of pixels comprising a first step of forming a device chip including one or a plurality of first functional devices corresponding to the plurality of pixels respectively on a first substrate, a second step of forming a plurality of second functional devices corresponding to the plurality of pixels respectively on a second substrate, a third step of forming a conductive paste for connecting the device chip and the second functional device on at least one of the first substrate and the second substrate, and a fourth step of adhering the first substrate and the second substrate.

In the third step, the conductive paste is preferably formed so as to be thicker than the first functional device on the first substrate and/or the second functional device on the second substrate. Accordingly, the first functional device and the second functional device can be prevented from coming into contact with each other at the portion other than the joint portion.

In the third step, the conductive paste is preferably formed by a screen process printing.

Preferably, the conductive paste is laminated by repeating the screen process printing a plurality of times, and is formed to be thicker than the first functional device on the first substrate and/or the second functional device on the second substrate. Accordingly, the first functional device and the second functional device can be prevented from coming into contact with each other at the portion other than the joint portion.

Preferably, a fifth step of forming a pattern for aligning with the screen mask used in the screen process printing is further included.

It is preferable to provide a mark on the first substrate or on the second substrate for checking printing misalignment of the screen process printing and to print a mark corresponding to the pattern formed on the first substrate or on the second substrate by the screen process printing on the first substrate or on the second substrate. Accordingly, printing of the conductive paste on the joint portion of the first substrate or of the second substrate with high accuracy is achieved.

Preferably, the pattern to be printed by the screen process printing has an opening structure. Accordingly, it can be prevented that the conductive paste formed in the pattern of closed shell structure, the first substrate, and the second substrate trap air in the atmosphere, and the air expands during heat hardening of the paste to deform the shape of the formed conductive paste.

Preferably, the above-described pattern is formed by the use of a screen mask.

Preferably, the first substrate or the second substrate is placed on an adsorption stage using an attachment for covering a blank space generated on the adsorption stage during the screen process printing.

Preferably, in the fourth step, the first substrate and the second substrate are adhered by means of an adhering jig constructed for adjusting the position of the first substrate and the second substrate while maintaining them substantially parallel with each other.

Preferably, the adhering jig includes at least three micro heads for performing fine adjustment of the positioning, and performs fine adjustment of the relative position between the first substrate and the second substrate by the use of the plurality of micro heads.

Further, preferably, the first substrate and the second substrate are adhered with each other by placing the second substrate on the adhering jig, placing the first substrate on at least three height adjusting screws disposed around the second substrate so as to project from the second substrate, and lowering the plurality of height adjusting screws in conjunction with each other so that the first substrate is placed on the second substrate in parallel with each other.

Preferably, the second substrate is smaller than the range defined by the plurality of height adjusting screws, and the first substrate is larger than the range defined by the positions of the plurality of height adjusting screws.

With such methods, positioning between the first substrate and the second substrate, and parallel adhesion between the first substrate and the second substrate are achieved.

Preferably, the first substrate and the second substrate are adhered with each other by placing the first substrate on the adhering jig, placing the second substrate on at least three height adjusting screws disposed around the first substrate so as to project from the first substrate, and lowering the plurality of height adjusting screws in conjunction with each other, so that the second substrate is placed on the first substrate in parallel therewith.

Preferably, the first substrate is smaller than the range defined by the plurality of height adjusting screws, and the second substrate is larger than the range defined by the plurality of height adjusting screws.

With such methods, the positioning between the first substrate and the second substrate and parallel adhesion between the first substrate and the second substrate are achieved.

Preferably, the first substrate and the second substrate are adhered with each other by placing the first substrate on the adhering jig, fixing the second substrate at a level higher than the first substrate from above by vacuum adsorption, and lowering the fixed first substrate from above, so that the first substrate is placed horizontally on the second substrate.

Preferably, the first substrate and the second substrate are adhered with each other by placing the second substrate on the adhering jig, fixing the first substrate from above at a level higher than the second substrate, lowering the fixed second substrate from above so that the second substrate is horizontally placed on the first substrate.

With such methods, the first substrate may be the same size as the second substrate, and positioning between the first substrate and the second substrate and parallel adhesion between the first substrate and the second substrate are achieved.

In the fourth step, preferably, the first substrate and the second substrate being in the adhered state are clamped between plates and heated, so that the conductive paste is hardened. Accordingly, the condition of hardening of the conductive paste adhering between the first substrate and the second substrate can be maintained uniformly, and a pressure applied to the conductive paste between the first substrate and the second substrate can be maintained uniformly, so that adhesion between the first and the second substrates can be well done.

Hardening of the conductive paste by heat is preferably performed in a vacuum oven. Accordingly, deterioration of the second functional device on the second substrate (for example, the organic electro-luminescence device) due to oxygen may be controlled.

Embodiments of the present invention will be described by way of further example only and with reference to the accompanying drawings, in which:-
Fig. 1 is a process drawing of a method of manufacturing a first functional device according to a first embodiment of the present invention.
Fig. 2 is a process drawing showing a method of manufacturing a second functional device according to the first embodiment of the present invention.
Fig. 3 is a drawing showing a state in which a first substrate and a second substrate are adhered with each other according to the first embodiment of the present invention.
Fig. 4 is a drawing showing a screen mask according to the first embodiment of the present invention.
Fig. 5 is a drawing showing an attachment according to the first embodiment of the present invention.
Fig. 6 is a drawing showing an adhering jig according to the first embodiment of the present invention.
Fig. 7 is a drawing showing a heat hardening process using a vacuum oven according to the first embodiment of the present invention.
Fig. 8 is a drawing showing an adhering jig according to a second embodiment of the present invention.
Fig. 9 is a process drawing showing a method of manufacturing a device chip including one or more of first functional devices according to a third embodiment of the present invention.
Fig. 10 is a process drawing showing a method of peeling and transferring the device chip including one or more of the first functional devices according to the third embodiment.
Fig. 11 is a drawing showing a state in which a first substrate and a second substrate are adhered with respect to each other according to the third embodiment of the present invention.
Fig. 12 is a drawing showing electronic equipment to which the electro-optical apparatus may be applied.

### [First Embodiment]

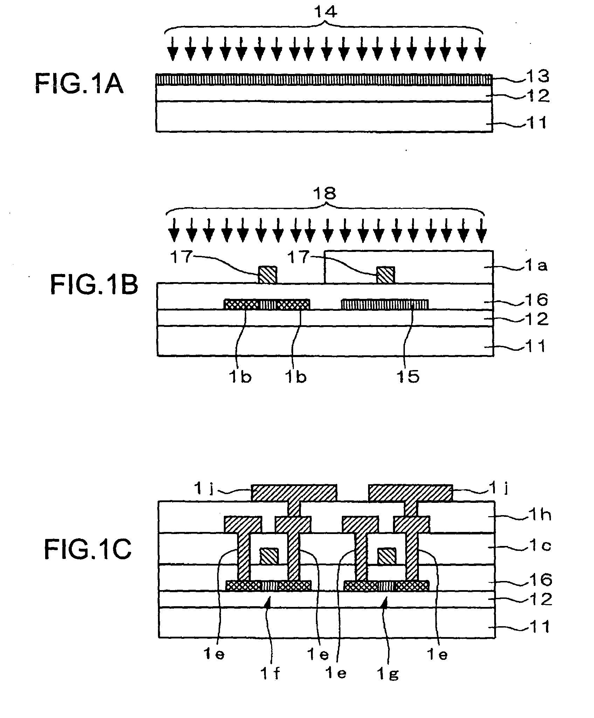

Fig. 1 is a process drawing of a method of manufacturing a first functional device according to a first embodiment of the present invention. In this case, the first functional device is a thin film transistor.

As shown in Fig. 1(a), a ground insulating film 12 is formed on a first substrate 11. For example, a silicon oxide film is preferably used as the ground insulating film 12. A semiconductor film 13 is formed on the ground insulating film 12 by PECVD method (Plasma Excitation CVD method) using SiH₄ as material gas, or by LPCVD method (Low Pressure CVD method) using Si₂H₆ as material gas. For example, an amorphous silicon (a-Si) film is preferably used as the semiconductor film 13. Subsequently, the semiconductor film 13 is crystallized by irradiation of laser beams 14. In this embodiment, a polycrystalline silicon (Poly-Si) film is obtained by crystallization. Then, the semiconductor film 13 is patterned into a desired configuration to obtain an active layer 15.

Then, as shown in Fig. 1(b), a gate insulating film 16 is formed by PECVD method using TEOS (tetraethoxysilane) as material gas or ECR-CVD method (Electron Cyclotron Resonance CVD method). Subsequently, a conductive film, such as metals, is formed on the gate insulating film 16, and the conductive film is patterned to form a gate electrode 17. P(Phosphorous) ion or B(Boron) ion is selectively injected using a resist mask 1a by means of ion implantation or ion doping 18 to form a source/drain region 1b.

Then, as shown in Fig. 1(c), a first interlayer insulating film 1c is formed and a contact hole is formed therein. Subsequently, a conductive film such as metals is formed on the first interlayer insulating film 1c and in the contact hole, and the conductive film is patterned to form a source/drain electrode 1e and a wiring (not shown). Accordingly, a CMOS circuit including an n-type thin film transistor 1f and a p-type thin film transistor 1g is formed. Further, a second interlayer insulating film 1h is formed and a contact hole is formed therein. Then, a pad metal film is formed on the second interlayer insulating film 1h and in the contact hole, and then patterned to obtain a connecting pad 1j. Although only one of each device is shown in Fig. 1, actually, a number of devices exist and are arranged.

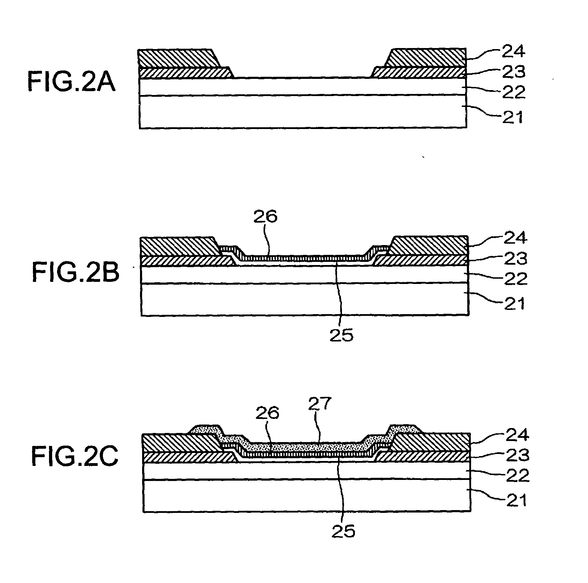

Fig. 2 is a process drawing showing a method of manufacturing a second functional device according to the first embodiment of the present invention. In this case, the second functional device is an organic electro-luminescence device.

As shown first in Fig. 2(a), a transparent conductive film (ITO film) is formed on a second substrate 21 to obtain an anode 22. A film of lyophilic material is formed and a hole is formed therein to obtain a lyophilic bank 23. A film of liquid-repellent material is formed and a hole is formed therein to obtain a liquid-repellent bank 24. Then, as shown in Fig. 2(b), PEDT (polyethylenedioxythiophene) is applied by an inkjet method (liquid drop discharging method) to form a positive hole transporting bed 25, and then a light emitting material is applied to form a light emitting layer 26. Then, as shown in Fig. 2(c), a cathode 27 is formed by a method such as metal mask depositing of low work function.

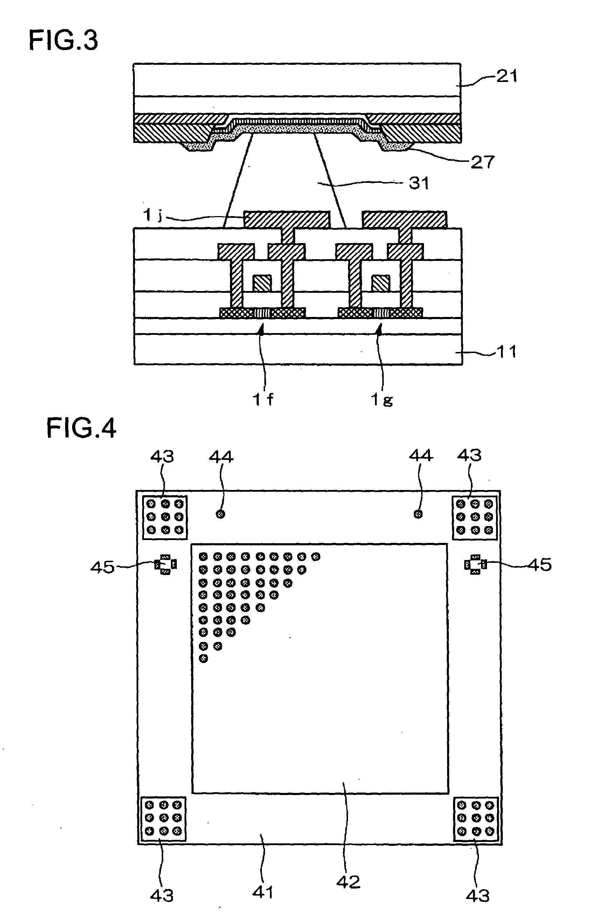

Fig. 3 is a drawing showing a state in which the first substrate and the second substrate are adhered with each other according to the first embodiment of the present invention. The connecting pad 1j formed on the first functional device of the first substrate 11 and the cathode 27 formed on the second functional device of the second substrate are adhered by the conductive paste 31 formed on the connecting pad 1j by screen process printing, and the connecting pad 1j of the first functional device and the cathode 27 formed on the second functional device are connected. It is also possible to form the conductive paste 31 on the cathode 27 formed on the second functional device by screen process printing and connect the same with the connecting pad 1j of the first functional device.

At this time, the conductive paste 31 is formed to be thicker than the first functional device on the first substrate 11 and the second functional device on the second substrate 21. According to this method, the first functional device and the second functional device may be prevented from coming into contact with each other at the portion other than the joint portion.

Fig. 4 is a drawing showing a screen mask 41 used for the screen process printing in the first embodiment of the present invention. In the screen process printing, a pattern 42 corresponding to the pixels, a pattern 43 for connecting the electrodes, a pattern 44 for aligning the first substrate or the second substrate with respect to the screen mask, and a mark 45 for checking printing misalignment of screen process printing are printed. These patterns to be printed by the screen process printing have opening structures. In contrast, when they are formed into closed (annular) structures and the conductive paste is formed, the conductive paste formed into an annular shape serves as a wall, and the first substrate and the second substrate adhered with each other serve as a bottom and a lid respectively, and thus air in the atmosphere is trapped therein. Then, when it is heated for hardening the paste, the air trapped by the two substrates and the conductive paste is expanded, which may result in deformation of the conductive paste formed thereon. Therefore, the conductive paste is formed into, for example, a dot-shape for securing outlets for air. In addition, preferably, the patterns to be printed have the same size. According to this method, the height of the patterns to be printed may be equalized.

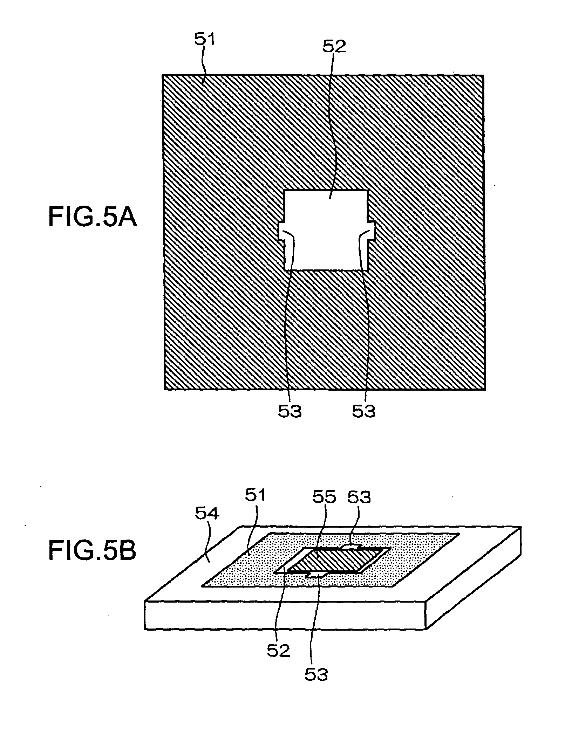

Fig. 5 is a drawing showing an attachment 51 to be used for the screen process printing according to the first embodiment of the present invention. Fig. 5(a) is a plan view of the attachment, Fig. 5(b) is a perspective view showing a state in which a printing substrate 55 is adsorbed on a stage 54 of a screen process printer by using the attachment. As shown in Fig. 5, the attachment 51 is used for covering a blank space generated on the adsorption stage 54 of the screen process printer. The attachment 51 includes a space (opening) 52 for installing the substrate and a notch 53 for inserting tweezers when taking out the substrate.

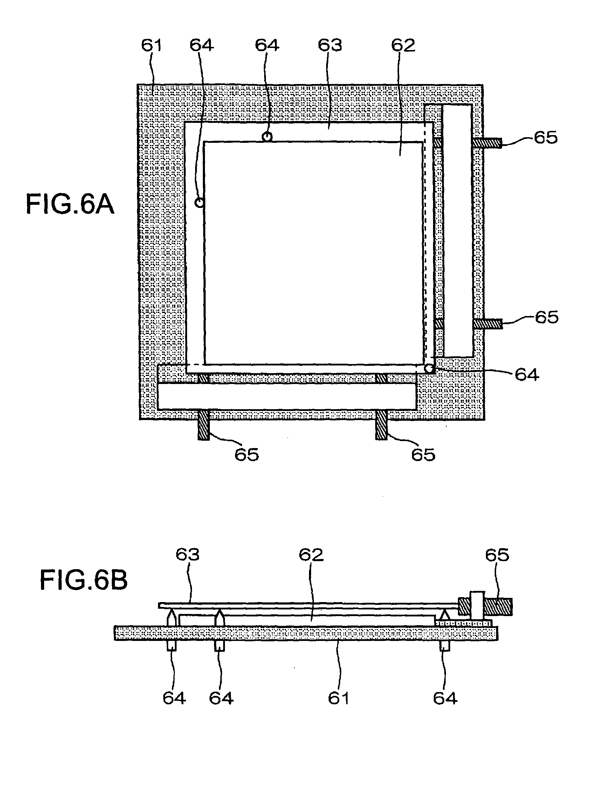

Fig. 6 is a drawing showing a jig for aligning the positions of the first substrate and the second substrate and adhering the first substrate and the second substrate in parallel with each other in the step of adhering the first substrate and the second substrate of the present invention. Fig. 6(a) is a plan view of the adhering jig when viewed from above, and Fig. 6(b) is a side view of the adhering jig. In Fig. 6, one of the substrate 62 and the substrate 63 corresponds to the first substrate and the other one of those corresponds to the second substrate.

As shown in Fig. 6, the jig 61 includes three height adjusting screws 64. As shown in Fig. 6(a), these height adjusting screws 64 are arranged in such a manner that the substrate 62 is smaller than the range defined by the three height adjusting screws 64, and the substrate 63 is larger than the range defined by these height adjusting screws 64. As shown in Fig. 6(b), the height adjusting screws 64 project from the substrate 62, and thus the substrate 62 and the substrate 63 do not come into contact with each other via the printed conductive paste.

As shown in Fig. 6, three or more micro heads 65 for fine adjustment are mounted to the jig 61 for aligning the substrate 62 and the substrate 63 disposed on the jig 61. Alignment of the substrate 63 is performed by using at least three of the three or more micro heads 65. AS shown in Fig. 6(b), the substrate 62 and the micro heads 65 do not come to contact with each other, and the substrate 63 and the micro heads 65 are in contact with each other, so that the position of the substrate 62 may be adjusted by sliding the substrate 63 by the micro heads.

Parallel adhesion between the substrate 62 and the substrate 63 are achieved by the use of the height adjusting screws 64 and the micro heads 65 described above. The substrate 63 is placed on the substrate 62 in parallel therewith by disposing the substrate 62 on the jig 61, disposing the substrate 63 on the three height adjusting screws 64, aligning the substrate 63 by using at least three of the three or more micro heads 65, and lowering all the three height adjusting screws 64.

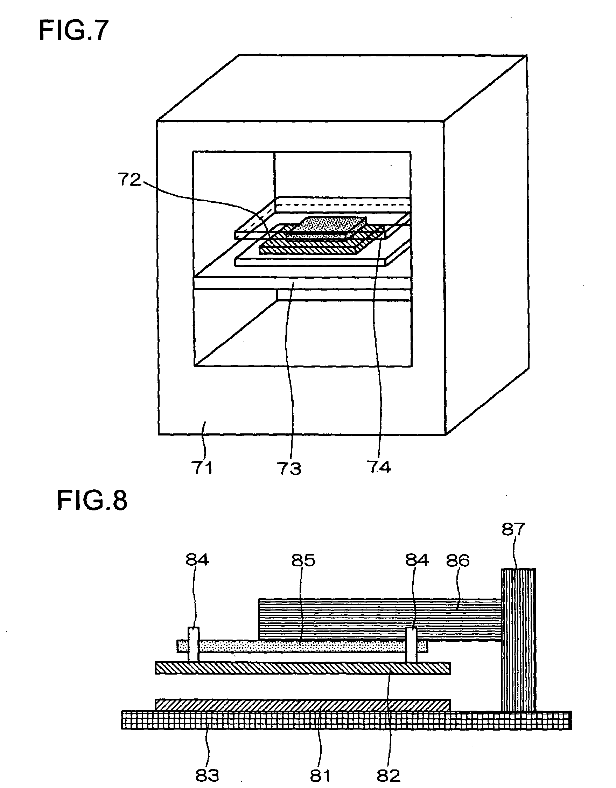

Fig. 7 is a perspective view showing a state in which an adhered substrate 72 is clamped between two flat substrates 73 and 74 and disposed in a vacuum oven. The adhered substrate 72 designates a substrate formed by adhering the first substrate and the second substrate. In order to maintain the hardening conditions of the conductive paste of the adhered substrate 72 equally and in order to maintain the distance between the first substrate and the second substrate evenly, the substrate 72 formed by adhering the first substrate and the second substrate is left on the flat substrate 73 at rest, the other flat substrate 74 is placed on top thereof so as to clamp the substrate 72 between the substrate 73 and the substrate 74, and then the conductive paste is heat hardened. In heat hardening the conductive paste, a vacuum oven 71 is used for placing the substrate 72 in a vacuum atmosphere in order to prevent the organic electro-luminescence device, which is the second functional device of the second substrate, from being deteriorated by oxygen.

### [Second Embodiment]

Fig. 8 is a drawing showing an adhering jig according to a second embodiment of the present invention. In the same manner as the first embodiment, in the step of printing a conductive paste on one substrate by screen process printing and adhering the substrate to the other substrate, a substrate 81 is placed on a stage 83, and a substrate 82 is fixed from above by vacuum adsorption at a level sufficiently higher than the substrate 81 so that the substrate 81 and the substrate 82 do not come into contact with each other via the conductive paste. For this fixation, an adsorption pad 84 is mounted. The adsorption pad 84 is disposed on an adsorption pad fixing plate 85, and the adsorption pad fixing plate 85 is fixed to an arm 86. The arm 86 is mounted to a column support 87, and the arm 86 is capable of moving the substrate 82 up and down in parallel with the substrate 81 by sliding along the column support 87. One of the substrate 81 and the substrate 82 corresponds to the first substrate and the other one corresponds to the second substrate. The substrate 81 and the substrate 82 may be the same size.

Hardening of the conductive paste by the vacuum oven 71 may be performed in the same manner as the first embodiment. More specifically, in order to maintain the hardening condition of the conductive paste of the substrate formed by adhering the substrate 81 and the substrate 82 equally and in order to maintain the distance between the first substrate 81 and the second substrate 82 evenly, the substrate formed by adhering the first substrate and the second substrate is left on the flat substrate 73 at rest, the other flat substrate 74 is placed on top thereof so as to clamp it between the substrate 73 and the substrate 74, and then the conductive paste is heat hardened. In heat hardening the conductive paste, a vacuum oven 71 is used for preventing the organic electro-luminescence device, which is the second functional device of the second substrate, from being deteriorated by oxygen.

### [Third Embodiment]

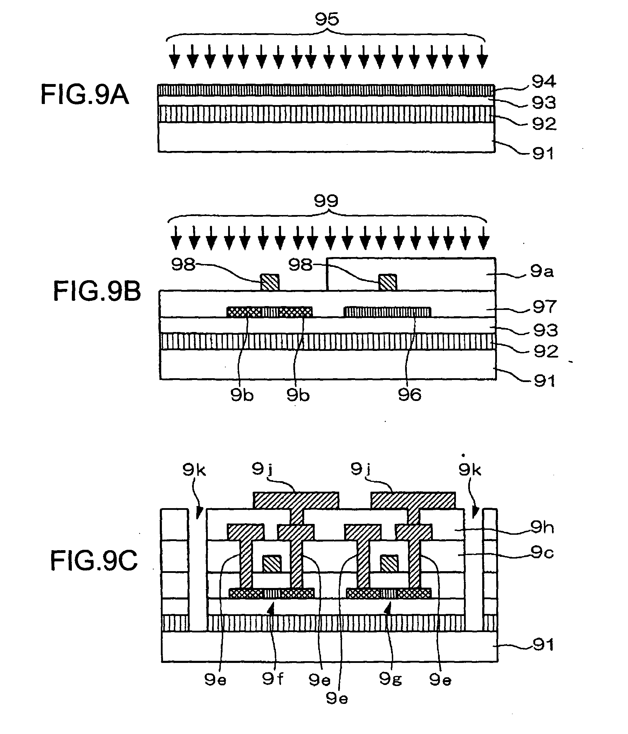

Fig. 9 is a process drawing showing a method of manufacturing a device chip including one or more of first functional devices according to a third embodiment of the present invention. The first functional device in this case is a thin film transistor.

As shown in Fig. 9(a), a peel ply 92 is formed on a provisional substrate 91, and then a ground insulating film 93 is formed thereon. The term "sacrificial layer" referred here is the one which has a property that the condition is changed when energy is applied to it (for example, by being exposed to irradiation of laser beams) and thus the extent of fixation with the provisional substrate 91 and/or the ground insulating film 93 is weakened. For example, an amorphous silicon film is preferably used.

Subsequently, on the ground insulating film 93, a semiconductor film 94 is formed by PECVD method using SiH₄ as material gas, or by LPCVD method using Si₂H₆ as material gas. For example, an amorphous silicon (a-Si) film is preferably used as the semiconductor film 94. Subsequently, the semiconductor film 94 is crystallized by irradiation of laser beams 95. In this embodiment, a polycrystalline silicon (Poly-Si) film is obtained by crystallization. Then, the semiconductor film 94 is patterned into a desired configuration to obtain an active layer 96.

Then, as shown in Fig. 9(b), a gate insulating film 97 is formed by PECVD method using TEOS as material gas or ECR-CVD method. Subsequently, a conductive film, such as metals, is formed on the gate insulating film 97, and the conductive film is patterned to form a gate electrode 98. P(Phosphorous) ion or B(Boron) ion is selectively injected using a resist mask 9a by means of ion implantation or ion doping 99 to form a source/drain region 9b.

As shown in Fig. 9(c), a first interlayer insulating film 9c is formed and a contact hole is formed therein. Subsequently, a conductive film such as metals is formed on the first interlayer insulating film 9c and in the contact hole, and the conductive film is patterned to form a source/drain electrode 9e and a wiring (not shown). Accordingly, a CMOS circuit including an n-type thin film transistor 9f and a p-type thin film transistor 9g is formed. Further, a second interlayer insulating film 9h is formed and a contact hole is formed therein. Then, a pad metal film is formed on the second interlayer insulating film 9h and in the contact hole, and then patterned to obtain a connecting pad 9j. Finally, a separation 9k is formed for separating the device chip. Although only one device chip is shown in Fig. 9, actually, a number of device chips exist and are arranged.

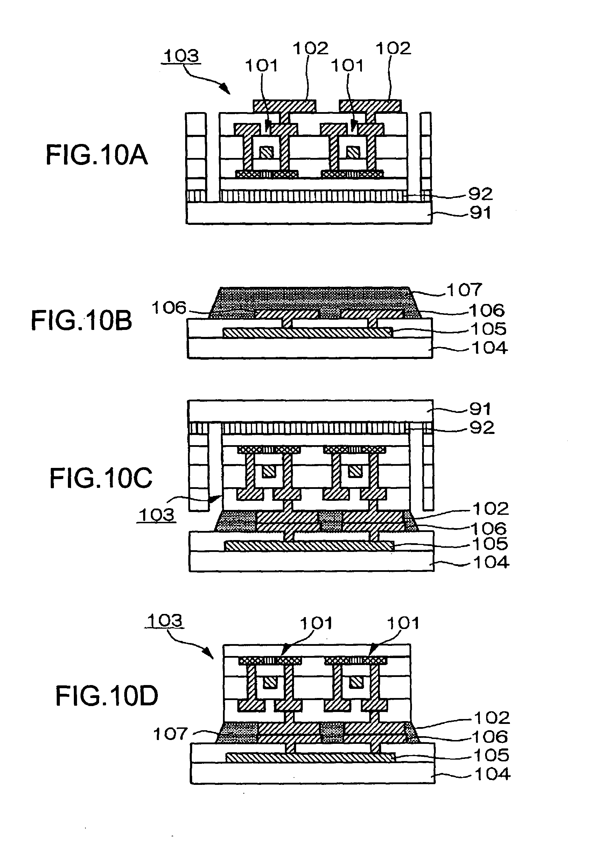

Fig. 10 is a process drawing showing a method of peeling and transferring the device chip including one or more of the first functional devices according to the third embodiment. As shown first in Fig. 10(a), the peel ply 92 is formed on the provisional substrate 91, and a third functional device 101 and a connecting pad 102 are formed thereon to form a device chip 103. Subsequently, as shown in Fig. 10(b), a wiring 105 and a connecting pad 106 are formed on a third substrate 104, and an adhesive agent 107 is applied thereon.

Then, as shown in Fig. 10(c), the upper surface of the provisional substrate 91 and the upper surface of the third substrate 104 are abutted against each other and brought into press-contact with each other, and then the connecting pad 102 of the device chip 103 and the connecting pad 106 of the third substrate are electrically connected by using an adhesive agent 107.

After that, laser beams are irradiated to the peel ply 92 from the back side of the provisional substrate 91 to cause peeling of the peel ply 92 by laser ablation and thus to make the device chip 103 including one or more of the third functional devices 101 peel from the provisional substrate 91. Accordingly, as shown in Fig. 10(d), the device chip 103 is transferred to the third substrate 104. As shown in Fig. 10(d), the device chip 103 is electrically connected to the connecting pad 102 of the device chip 103 including one or more of the thin film transistors 101 and the connecting pad 106 of the third substrate 104 on which the wiring 105 is formed thereon are electrically connected.

A method of manufacturing the second functional device according to the third embodiment of the present invention will now be described. Here, a case in which the organic electro-luminescence device is used as the second functional device is considered. In this case, the method of manufacturing the second functional device according to the first embodiment described above may be followed (see Fig. 2). As a consequence, a fourth substrate including a fourth functional device is formed.

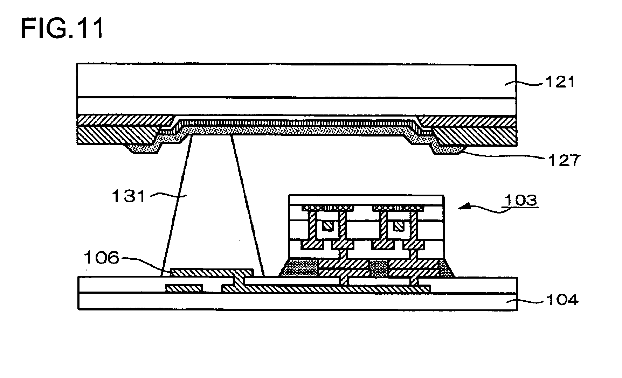

Fig. 11 is a drawing showing a state in which the first substrate and the second substrate are adhered with respect to each other according to the third embodiment of the present invention. The connecting pad 106 formed on the third substrate 104 and a cathode 127 formed on the second functional device (the organic electro-luminescence device) of the second substrate 121 are adhered with each other by a conductive paste 131 formed on the connecting pad 106 by the screen process printing, and the connecting pad 106 of the first functional device and the cathode 127 formed on the second functional device are connected. It is also possible to form the conductive paste 131 on the cathode 127 formed on the second functional device by the screen process printing and connect it with the connecting pad 106 of the first functional device.

At this time, the conductive paste 131 is formed to be thicker than the device chip 103 including one or more of the first functional devices on the third substrate 104 and the second functional device on the second substrate 121. With this method, the first functional device and the second functional device are prevented from coming into contact with the portion other than the joint portion.

In the screen process printing, the attachment stated in the first embodiment is used according to the size of the substrate, then the substrate is arranged on the stage of the printer, and then the conductive paste is printed using the screen mask stated in the first embodiment described above.

The step of adhering the third substrate 104 and the second substrate 121 according to the present invention is performed by using the adhering jig stated in the first embodiment. In this case, one of the substrate 11 and the substrate 21 corresponds to the first substrate, and the other one of them corresponds to the second substrate. This step can be also performed by using the adhering jig stated in the second embodiment. In this case, one of the substrate 51 and the substrate 52 corresponds to the first substrate and the other one of them corresponds to the second substrate.

In order to maintain the hardening conditions of the conductive paste of the adhered substrate equally and in order to maintain the distance between the third substrate 104 and the second substrate 121 evenly, the substrate formed by adhering the third substrate 104 and the second substrate 121 is left on a flat substrate at rest, another flat substrate is placed on top thereof so as to clamp it between the substrates, and then the conductive paste is heat hardened. In heat hardening the conductive paste, a vacuum oven is used for preventing the organic electro-luminescence device, which is the second functional device of the second substrate, from being deteriorated by oxygen.

### [Fourth Embodiment]

Various types of electronic equipment constructed by applying the electro-optical apparatus according to the present invention will now be described.

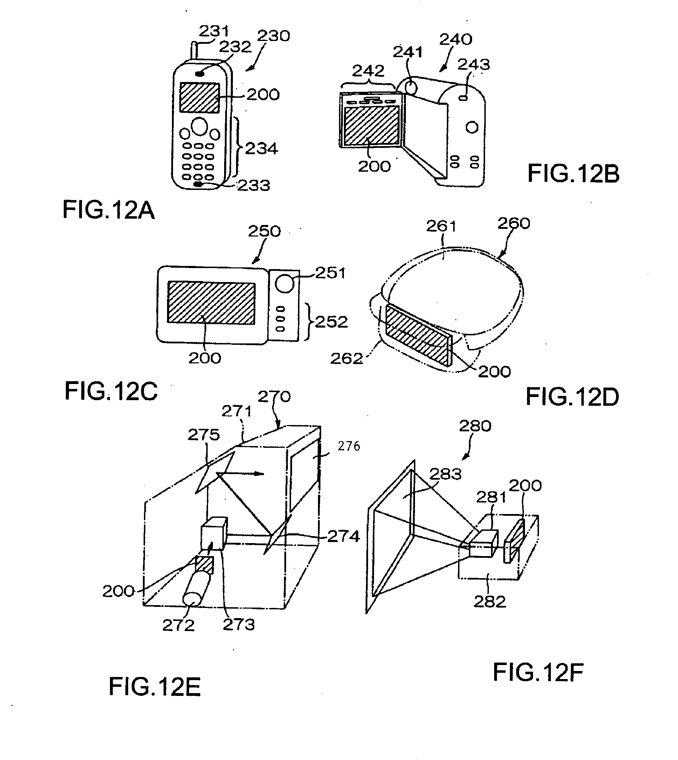

Fig. 12 is a drawing showing electronic equipment to which the electro-optical apparatus may be applied. Fig. 12(a) is an example of application to a mobile telephone set, in which the mobile telephone set 230 includes an antenna unit 231, an audio output unit 232, an audio input unit 233, an operation unit 234, and the electro-optical apparatus 200 according to the present invention. In this manner, the electro-optical apparatus according to the present invention can be used as a display unit. Fig. 12(b) is an example of application to a video camera, in which the video camera 240 includes an image receiving unit 241, an operation unit 242, an audio input unit 243, and the electro-optical device 200 according to the present invention. In this manner, the electro-optical apparatus according to the present invention can be used as a finder or a display unit. Fig. 12(c) is an example of application to a portable personal computer (so-called PDA), in which the computer 250 includes a camera unit 251, an operation unit 252, and the electro-optical apparatus 200 according to the present invention. In this manner, the electro-optical apparatus according to the present invention can be used as a display unit.

Fig. 12(d) is an example of an application to a head-mount display, in which the head mount display 260 includes a band 261, an optical system housing 262, and the electro-optical apparatus 200 according to the present invention. In this manner, the electro-optical apparatus according to the present invention can be used as an image display source. Fig. 12(e) is an example of application to a rear-type projector, in which the projector 270 includes a light source 272, a composite optical system 273, mirrors 274, 275, a screen 276, and the electro-optical apparatus 200 according to the present invention in a housing 271. In this manner the electro-optical apparatus according to the present invention can be used as an image display source. Fig. 12(f) is an example of application to a front-type projector, in which the projector 280 includes an optical system 281 and the electro-optical apparatus 200 according to the present invention in an enclosure 282, so that an image can be displayed on a screen 283. In this manner the elector-optical apparatus according to the present invention can be used as an image display source. In addition to these applications, it may be used in any electronic equipment to which a display device is applicable, including a facsimile apparatus having a display function, a finder of a digital camera, a portable TV, an electronic databook, an electric bulletin board, and a display for advertisement.

## Claims

1. An electro-optical apparatus having a plurality of pixel areas comprising:
a first substrate formed with a plurality of first functional devices corresponding to the plurality of pixel areas respectively; and
a second substrate formed with a plurality of second functional devices corresponding to the plurality of pixel areas and being adhered to the first substrate,
**characterized in that** the first functional devices and the second functional devices are connected with respect to each other via a conductive paste.

2. An electro-optical apparatus having a plurality of pixel areas comprising:
a first substrate formed with a device chip including one or a plurality of first functional devices corresponding to the plurality of pixel areas respectively; and
a second substrate formed with a plurality of second functional devices corresponding to the plurality of pixel areas respectively and being adhered to the first substrate,
**characterized in that** the device chip and the second functional devices are connected with respect to each other via a conductive paste.

3. An electro-optical apparatus according to Claim 1 or 2, **characterized in that** the conductive paste is formed by a screen process printing.

4. An electro-optical apparatus according to any one of Claims 1 to 3, **characterized in that** the conductive paste also serves as a spacer between the first substrate and the second substrate.

5. An electro-optical apparatus according to any one of Claims 1 to 4, **characterized in that** the first functional device is a thin film transistor.

6. An electro-optical apparatus according to any one of Claims 1 to 4, **characterized in that** the second functional device is an organic electro-luminescence device.

7. Electronic equipment comprising an electro-optical apparatus according to any one of Claims 1 to 6.

8. A method of manufacturing an electro-optical apparatus having a plurality of pixel areas comprising:
a first step of forming a plurality of first functional devices corresponding to the plurality of pixel areas respectively on a first substrate;
a second step of forming a plurality of second functional devices corresponding to the plurality of pixel areas on a second substrate;
a third step of forming a conductive paste for connecting the first functional device and the second functional device on at least one of the first substrate or the second substrate; and
a fourth step of adhering the first substrate and the second substrate.

9. A method of manufacturing an electro-optical apparatus having a plurality of pixel areas comprising:
a first step of forming a device chip comprising one or a plurality of first functional devices corresponding to the plurality of pixel areas respectively on a first substrate;
a second step of forming a plurality of second functional devices corresponding to the plurality of pixel areas respectively on a second substrate;
a third step of forming a conductive paste for connecting the device chip and the second functional device on at least one of the first substrate and the second substrate; and
a fourth step of adhering the first substrate and the second substrate.

10. A method of manufacturing an electro-optical apparatus according to Claim 8 or 9, **characterized in that** the conductive paste is formed so as to be thicker than the first functional device on the first substrate and/or the second functional device on the second substrate.

11. A method of manufacturing an electro-optical apparatus according to any one of Claims 8 to 10, **characterized in that** the conductive paste is laminated by repeating the screen process printing a plurality of times, and is formed to be thicker than the first functional device on the first substrate and/or the second functional device on the second substrate.

12. A method of manufacturing an electro-optical apparatus according to Claim 11, further comprising a fifth step of forming a pattern for aligning with the screen mask used in the screen process printing on the first substrate or the second substrate.

13. A method of manufacturing an electro-optical apparatus according to Claim 12, **characterized in that** a mark is provided on the first substrate or on the second substrate for checking printing misalignment of the screen process printing and a mark corresponding to the pattern formed on the first substrate or on the second substrate is printed on the first substrate or on the second substrate by the screen process printing.

14. A method of manufacturing an electro-optical apparatus according to any one of Claims 11 to 13, **characterized in that** the first substrate or the second substrate is placed on an adsorption stage using an attachment for covering a blank space generated on the adsorption stage during the screen process printing.

15. A method of manufacturing an electro-optical apparatus according to any one of Claims 8 to 14, **characterized in that** the first substrate and the second substrate are adhered by means of an adhering jig constructed for adjusting the position of the first substrate and the second substrate while maintaining them substantially parallel with each other in the fourth step.

16. A method of manufacturing an electro-optical apparatus according to Claim 15, **characterized in that** the adhering jib comprises at least three micro heads for performing fine adjustment of the positioning, and performs fine adjustment of the relative position between the first substrate and the second substrate by the use of the plurality of micro heads.
